Europäisches Patentamt

European Patent Office

Office européen des brevets

(19)

(11) Numéro de publication: **0 291 387**
A1

## (12) DEMANDE DE BREVET EUROPEEN

(21) Numéro de dépôt: **88401070.3**

(22) Date de dépôt: **03.05.88**

(51) Int. Cl.⁴: **A 61 B 5/02**
G 01 N 24/08, G 01 F 1/716

(30) Priorité: **12.05.87 FR 8706650**

(43) Date de publication de la demande:
**17.11.88 Bulletin 88/46**

(84) Etats contractants désignés: **DE ES GB IT NL**

(71) Demandeur: **GENERAL ELECTRIC CGR SA.**
**13, Square Max-Hymans**
**F-75015 Paris (FR)**

(72) Inventeur: **Le Roux, Patrick**
**CABINET BALLOT-SCHMIT 84, Avenue Kléber**
**F-75116 Paris (FR)**

(74) Mandataire: **Ballot, Paul Denis Jacques et al**
**Cabinet Ballot-Schmit 84, avenue Kléber**
**F-75116 Paris (FR)**

(54) **Procédé de mesure des flux dans une expérimentation de résonance magnétique nucléaire.**

(57) On mesure les flux (63,64) dans une expérimentation de résonance magnétique nucléaire en provoquant le basculement de l'orientation des moments magnétiques des particules situées dans une tranche (26) et en ne provoquant, ultérieurement, une réflexion de la dispersion des phases des signaux de résonance magnétique que pour des particules qui ont migré dans une tranche (27,28) adjacente à la tranche dans laquelle le basculement a été entrepris. On montre que la dynamique relative du signal de RMN mesuré concernant les parties mobiles par rapport au signal mesuré concernant les parties fixes devient infini.

FIG_4

EP 0 291 387 A1

**Description**

## PROCEDE DE MESURE DES FLUX DANS UNE EXPERIMENTATION DE RESONANCE MAGNETIQUE NUCLEAIRE

La présente invention a pour objet un procédé de mesure des flux dans une expérimentation de résonance magnétique nucléaire (RMN). De telles expérimentations sont employées dans le domaine des mesures physiques depuis fort longtemps; elles sont aussi employées depuis quelques années dans le domaine médical. En effet la RMN s'est affirmée dernièrement comme une des principales techniques d'investigation à l'intérieur des corps humains : elle ne provoque aucun traumatisme, elle n'est pas pénible. Alors que les premiers developpements de cette technique avaient concerné la connaissance de l'architecture, de l'anatomie, des parties fixes dans les corps, l'évolution du besoin s'oriente maintenant vers la connaissance des caractéristiques des parties en mouvement dans les corps. Par exemple dans le corps humain on rencontre un grand besoin de connaitre la distribution des flux de sang dans le coeur.

On connait plusieurs techniques de mesure des flux dans des expérimentations de RMN. En particulier il est décrit, dans une demande de brevet européen 84 307746.2 déposée le 09 NOVEMBRE 1984, une technique de réduction de la sensibilité au mouvement dans des images obtenues par RMN. La représentation des flux s'y effectue au moyen de deux acquisitions successives et complémentaires. Dans une première acquisition on ne compense pas l'effet du mouvement des parties mobiles dans la mesure : les informations obtenues ne rendent en définitive compte que de tout ce qui est fixe dans le corps. Lors d'une deuxième acquisition, on compense les effets de la vitesse des parties en mouvement dans le signal de RMN de telle façon que ces parties en mouvement contribuent effectivement à ce signal. En comparant les informations acquises à l'issue de la deuxième acquisition à celles acquises à l'issue de la première, on déduit des informations relatives aux parties mobiles seules. L'inconvénient de cette technique est qu'elle nécessite deux acquisitions. De plus, pour des raisons qui seront expliquées plus loin chaque acquisition doit être faite en synchronisant les expérimentations. Ce faisant, implicitement, on fait l'hypothèse d'une certaine stationnarité du phénomène mobile étudié. Cette hypothèse de stationnarité périodique du phénomène étudié est d'autant moins justifiée qu'elle concerne des périodes longues. Ceci est tout à fait le cas lorsque l'on obtient l'information à l'issue de deux acquisitions qui sont déjà longue en elles-mêmes.

Une autre technique a été présentée par MM.G.BIELKE, S.MEINDL, W.V. SEELEN, P. PFANNENSTIEL, de la Deutsche Klinik Für Diagnostik, WIESBADEN ALLEMAGNE FEDERALE, au cinquième congrès d'imagerie médicale par RMN de la SMRM du 19 au 22 Août 87 à Montréal au Quebec (volume 1 p. 76 et 77). Cette technique s'intitule : "Quantitative assessment of laminar volume flow by orthogonal excitation with multiple echoes". Selon cette technique, on excite les moments magnétiques des noyaux d'un corps se trouvant dans une tranche déterminée de ce corps. On les fait basculer et, à chaque séquence d'excitation, on soumet les moments magnétiques ainsi basculés à une excitation ultérieure, dite à écho de spin qui a la particularité d'être à large bande. C'est à dire que l'effet de cette excitation à écho de spin n'est pas cantonné aux protons qui sont restés dans la tranche (les protons fixes) mais qu'il concerne aussi les protons qui ont quitté la tranche (ceux qui sont en mouvement). Pour effectuer la sélection de la tranche on utilise un gradient codeur dit de sélection. Selon une technique connue lors de la détection du signal on utilise un gradient de lecture. Dans la technique évoquée le gradient de lecture a la particularité d'être orienté dans le même sens que le gradient de sélection. Il en résulte immédiatement que les parties mobiles contribuent alors au signal de RMN avec, au moment de la mesure, une fréquence décalée de la fréquence centrale de résonance. Le décalage est représentatif de la force du gradient appliqué (ce qui était connu) et de la distance qui sépare les protons concernés de la tranche où ils se trouvaient lors de l'excitation. En quelque sorte on mesure la distance que ces protons ont parcourue. Pour des durées prédéterminées d'expérimentation on en déduit la vitesse des protons considérés.Dans la pratique l'image de la tranche est projetée dans un plan perpendiculaire à elle-même : sa projection ressemble à une ligne. Les parties en mouvement apparaissent alors comme des décrochements localisés par rapport à cette ligne. D'une manière préférée l'image est obtenue avec une technique d'imagerie dite à codage de phase ou encore 2DFT. Dans cette technique d'imagerie une pluralité de séquences excitations-mesure est entreprise, et un deuxième gradient codeur est appliqué entre l'impulsion d'excitation et l'impulsion d'écho de spin de chaque séquence. La valeur de ce gradient évolue d'une séquence à l'autre au cours de l'expérimentation. L'image représentée est une image obtenue par projection sur un plan contenant l'axe de ce gradient de codage de phase et l'axe de lecture (qui dans le cas présent est également l'axe de sélection).

Cette dernière technique présente un inconvénient essentiel : la dynamique des informations présentées est défavorable au phénomène que l'on veut justement montrer. En effet le décrochement constaté par rapport à l'alignement dépend, comme on l'a vu plus haut, de la vitesse des parties en mouvement. Par exemple en médecine ce décrochement peut représenter le sang dans une artère, dans une veine, ou dans le coeur . Or le diagramme des vitesses d'un fluide est continu. Sur les parois du tube d'écoulement le flux est presque nul, au centre du tube il est maximum. Il en résulte que le décrochement par rapport à la ligne aura sensiblement l'air d'une portion de parabole. Les deux ailes de cette parabole s'appuient sur la ligne projetée : elles représentent les parties dont le flux est faible. Dans une image d'une section d'un corps humain réel, on peut par exemple considérer que le diamètre d'un tel tube d'écoulement est de l'ordre de 1 cm, soit sensiblement 30 fois inférieur au diamètre du corps. Comme l'image est une image en projection, à l'endroit du décrochement, on voit se mêler les traces des parties en mouvement à faible vitesse et les traces des parties fixes situées à l'aplomb (à cause de la projection) de part et d'autre du tube d'écoulement considéré. Or les traces des parties fixes sont sensiblement 30 fois plus fortes (en réalité 29 fois = 30 - 1) que les traces des parties mobiles. En définitive celles ci ne sont pas vues. L'information relative à ces parties mobiles apparaît comme un bruit par rapport au signal relatif aux parties fixes.

Dans l'invention on remédie aux inconvénients cités en proposant une mesure des flux des parties mobiles, dans laquelle une seule acquisition est nécessaire, et dans laquelle l'image des parties fixes est supprimée de manière à augmenter la dynamique utile de représentation des parties en mouvement. Pour l'essentiel dans l'invention on excite une tranche prédéterminée du corps en faisant basculer, d'une manière préférée de 90°, les moments magnétiques des particules du corps situé dans cette tranche : que ces particules soient fixes ou mobiles. Au cours de la séquence, au moyen d'une excitation ultérieure du type à écho de spin on provoque la réflexion de la dispersion de la phase du signal de précession libre des moments magnétiques excités. Cette dispersion est due aux inhomogénéités du champ orientateur de la machine, cette excitation ultérieure est dite, pour cette raison réfléchissante. Dans l'invention, cette excitation réfléchissante à la particularité, contrairement au second état de la technique cité, de ne pas être excessivement à large bande mais d'être à bande normale, et d'être appliquée, en présence d'un même gradient de sélection, à une fréquence décalée en fréquence de la fréquence centrale de résonance, de manière à ne provoquer la réflexion utile de phase que pour des particules qui se trouvent maintenant dans une tranche adjacente à la tranche préalablement excitée. Il en résulte qu'au moment de la réception la renaissance du signal de RMN ne concerne que les particules qui avaient quitté la tranche préalablement excitée. Les particules fixes, qui ne l'avaient pas quitté ne contribuent pas au signal de RMN. Il en résulte que la dynamique du signal reçu peut être consacrée à une meilleure représentation du diagramme des flux. Dans l'état de la technique cité, l'impulsion réfléchissante pouvait ne pas être à large bande mais être en fait monofréquence et appliquée en l'absence de gradient de sélection. Ceci revient au même. Pour le reste dans l'invention, au moment de la lecture,on applique également au corps un gradient de champ orienté dans le même sens que le gradient qui a servi à faire la sélection. A chaque séquence de l'expérimentation on modifie aussi la force d'un gradient de codage de phase de manière à disposer d'une série de mesures utiles à la représentation de l'image.

L'invention concerne donc un procédé de mesure des flux dans une expérimentation de RMN dans laquelle
- on soumet un corps à examiner, comportant des parties en mouvement, à un champ magnétique orientateur,
- on excite sélectivement au moins une tranche de ce corps de manière à faire basculer l'orientation des moments magnétiques des parties de ce corps situées dans cette tranche,
- on relève le signal de résonance résultant de cette excitation basculante, et
- on le traite pour en extraire une information de flux relative aux parties en mouvement,
- l'excitation comportant, ultérieurement à l'excitation basculante mais antérieurement au relevé, l'application d'au moins une excitation réfléchissante dont l'action est limitée dans l'espace à au moins une tranche du corps, ladite tranche étant adjacente à la tranche excitée sélectivement par l'excitation basculante.

Selon une caractéristique essentielle, l'excitation comporte l'application d'au moins une excitation réfléchissante dont l'action est simultanément limitée dans l'espace à au moins deux tranches voisines, ces tranches voisines étant adjacentes de part et d'autre à au moins une tranche du corps excitée sélectivement par l'excitation basculante.

Selon une autre caractéristique essentielle, l'excitation basculante comporte l'excitation limitée simultanément à au moins deux tranches voisines du corps et l'excitation réfléchissante est telle qu'au moins une région de l'espace où est limitée son action est une région adjacente aux deux tranches voisines ainsi soumises à l'excitation basculante.

Selon une autre caractéristique essentielle, la région de l'espace ou l'excitation basculante excerce son action empiète en partie sur la région de l'espace où l'excitation réfléchissante exerce son action.

L'invention sera mieux comprise à la lecture de la description qui suit et à l'examen des figures qui l'accompagnent . Elles ne sont données qu'à titre indicatif et nullement limitatif de l'invention. Les figures montrent :

- figure 1 : une représentation schématique d'une machine pour la mise en oeuvre du procédé selon l'invention;
- figures 2a à 2d : des chronogrammes de signaux intervenant dans le procédé selon l'invention;
- figures 3a à 3e : des particularités spectrales schématiquement représentées, des excitations appliquées au corps à examiner ;
- figure 4 : une représentation schématique d'un corps muni de tubes d'écoulement ;
- figures 5a et 5b : une variante multicoupe du procédé selon l'invention ;
- figure 6 : la représentation d'une image de flux avec mise en oeuvre du procédé selon la variante ;
- figures 7a et 7b : une modification des spectres précédents pour améliorer la lisibilité de l'image ;
- figure 8 : un chronogramme montrant l'allure temporelle d'une des enveloppes des excitations radiofréquence qui satisfont dans un exemple aux diagrammes spectraux des figures 3 et 5.

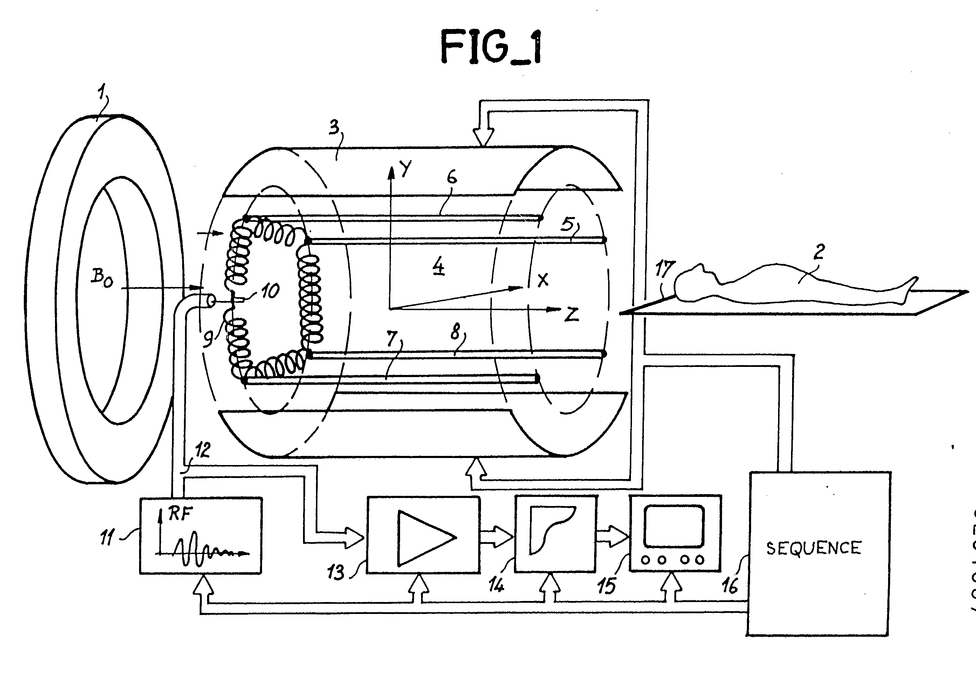

La figure 1 représente une machine de RMN utilisable pour la mise en oeuvre du procédé selon l'invention. Cette machine comporte principalement des moyens, symbolisés en 1, pour soumettre un corps 2 à un champ $B_0$ magnétique, continu, homogène, et intense dit orientateur. Par des bobines de gradient 3 le corps 2, une fois introduit dans la machine, peut être soumis temporairement à des champs magnétiques supplémentaires dit gradient de champ utilisables d'une manière connue avec des procédés d'imagerie. Dans ces conditions, dans des séries de séquences d'excitation, le corps est soumis à des excitations électromagnétiques radiofréquence appliquées par une antenne 4 comprenant par exemple un ensemble de quatre conducteurs rayonnants 5 à 8 alimentés par un circuit oscillant 9 auquel est couplé par un couplage 10 un générateur 11 d'excitations radiofréquences. Lorsque les excitations cessent l'antenne 4 peut servir à mesurer le signal de désexcitation. Ce signal de désexcitation, dit aussi de RMN, est acheminé au moyen d'un duplexeur 12 sur des moyens de réception 13. Les moyens de réception sont en relation avec des moyens de traitement 14 qui eux mêmes peuvent être en relation avec des moyens de visualisation 15 des images des parties désirées du corps. Tout ces organes sont pilotés par un séquenceur 16. La machine comporte en outre d'autres moyens logistiques, tels qu'un plateau 17 pour approcher le corps du patient à l'intérieur du tunnel d'examen, et qui sont sans incidence sur la présente invention.

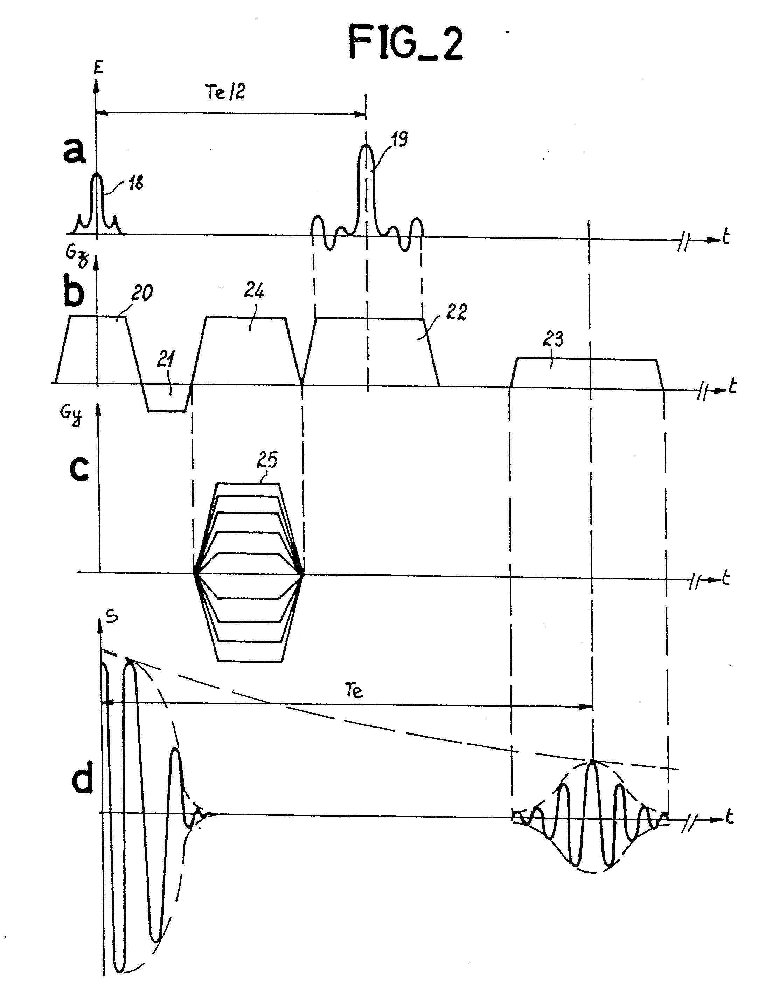

Les figures 2a et 2d montrent des chronogrammes de signaux appliqués au corps et reçus de celui-ci au cours d'une séquence d'une série de séquences de l'expérimentation RMN selon l'invention. Dans l'invention, l'excitation, figure 2a, est essentiellement une excitation du type dit avec écho de spin. L'excitation comporte à cet effet une première excitation basculante 18 qui basculer de 90° l'orientation des moments magnétiques des particules situées dans une région à examiner du corps. Elle comporte également une deuxième excitation réfléchissante 19 , dite aussi communément d'écho de spin, dont l'objet est de faire varier de 180° l'orientation des moments magnétiques qui sont en train de précesser librement sous l'effet de l'excitation basculante 18 et du champ $B_0$. Alors que les inhomogénéités du champ orientateur $B_0$ ont provoqué une dispersion de l'orientation, de la phase, de précession des différents moments magnétiques des particules excitées dans la région considérée, l'excitation réfléchissante provoque une réflexion de cette dispersion. De cette manière, le signal de RMN S, représenté sur la figure 2d, qui s'évanouit très rapidement après l'excitation basculante 18, renait au bout d'un temps d'écho $T_e$. Le temps $T_e$ est égal au double de la durée qui sépare l'application des excitations basculante 18 et réfléchissante 19.

De manière à localiser précisément une région considérée du corps, une tranche, on applique simultanément avec l'excitation basculante 18 une impulsion 20 d'un gradient de sélection (fig. 2b). Pour simplifier l'explication, et en se référant à la figure 1, le gradient appliqué dans un exemple est un gradient de champ orienté selon l'axe Z colinéaire au champ orientateur. On sait qu'en agissant ainsi on peut provoquer la naissance d'un signal de résonance dans une tranche limitée transverse dans le corps 2. L'impulsion 20 est suivie d'une manière classique sur le même axe d'une impulsion 21 de recodage de phase à cause du déphasage impliqué par le gradient de sélection. Au moment de l'application de l'impulsion réfléchissante 19, une impulsion 22 d'un gradient orienté également suivant l'axe Z est aussi appliquée. On montrera plus loin comment cette impulsion 22 en combinaison avec une impulsion réfléchissante 19 spéciale selon l'invention permet de sélectionner en fait une tranche adjacente à la tranche examinée.

La mesure du signal est effectuée en présence d'une impulsion 23 d'un gradient dit de lecture qui dans le cas présent est également un gradient orienté selon l'axe Z, c'est à dire selon l'axe qui a servi à faire la sélection de la tranche. De manière à compenser les déphasages provoqués au moment de la lecture du signal de RMN par le gradient de lecture on applique entre les deux impulsions radiofréquence basculante et réfléchissante une impulsion 24, d'un type connu, appelée impulsion de précodage de lecture. Le fait de choisir un axe de lecture colinéaire à l'axe de sélection implique que le signal de RMN reçu correspond en fait à une projection, selon une direction parallèle au plan de la tranche, des contributions au signal de résonance des particules se trouvant à l'origine dans cette tranche. Au moyen d'une impulsion dite de codage de phase 25, appliquée sur un axe perpendiculaire au précédent, içi dans un exemple l'axe Y, et dont l'amplitude varie d'une séquence à l'autre de la série des séquences de l'expérimentation, on peut collecter une série de mesures. On peut arriver avec ces mesures à reconstruire une image de la projection. La reconstruction de cette image emprunte une méthode d'imagerie dite 2 DFT.

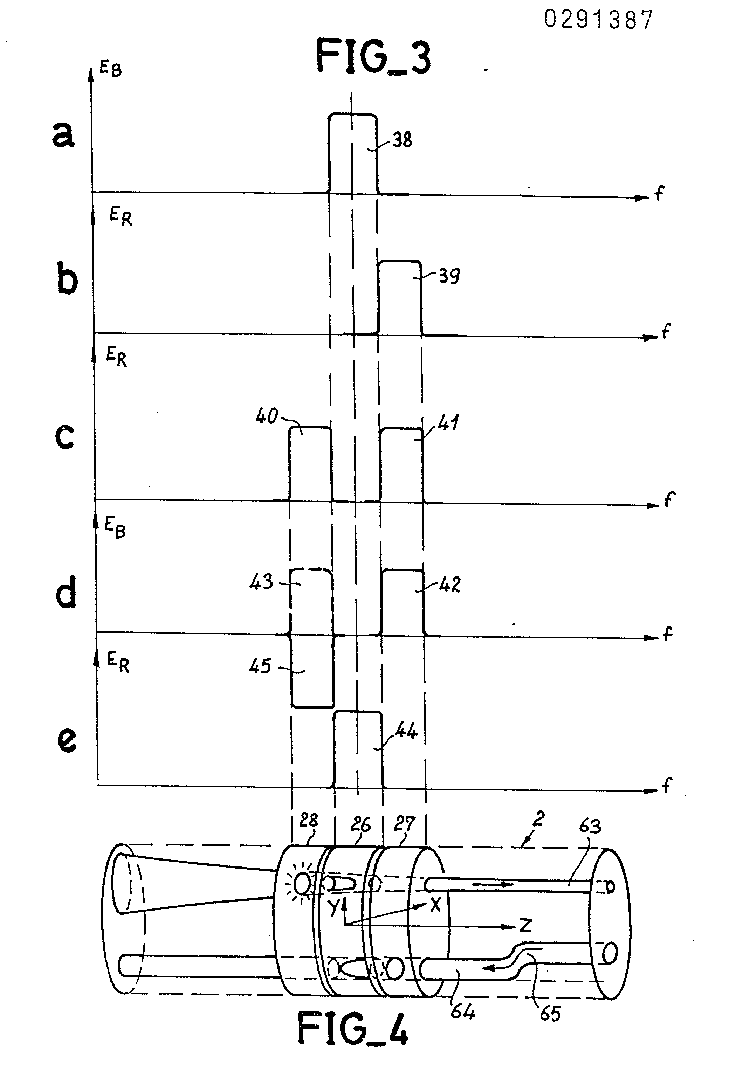

Les figures 3a à 3e, en combinaison avec la figure 4, montrent les particularités de l'invention. Sur la figure 4 on a représenté schématiquement le corps 2 dont on a plus particulièrement dessiné trois tranches respectivement 26 à 28 adjacentes les unes aux autres sensiblement perpendiculairement à l'axe Z. On sait que la présence d'un gradient pendant l'application des excitations basculante $E_B$ et réfléchissante $E_R$, a pour effet de modifier les conditions locales de résonance. Essentiellement, la fréquence de résonance $\underline{f}$ évolue dans la tranche selon son abcisse mesurée sur l'axe Z : sur l'axe d'application du gradient. Classiquement, figure 3a, le spectre 38 de l'excitation 18 est tel qu'il ne provoque un basculement à 90° que des moments magnétiques des particules se trouvant dans la tranche 26. Les moments magnétiques des particules se trouvant à l'extérieur de la tranche ne sont pas basculés. La représentation du spectre de cette excitation sous la forme d'une impulsion rectangulaire n'est en fait que schématique. Elle tient compte d'une approximation linéaire qu'il pourrait y avoir entre l'angle de basculement et le coefficient de la composante spectrale qui provoque, dans les conditions locales concernées, le basculement attendu. Dans la pratique cette approximation linéaire est fausse. Cependant pour l'explication il est plus simple d'utiliser un tel diagramme. On sait par ailleurs tracer le diagramme du spectre exact pour obtenir un basculement à 90° des moments magnétiques des particules situées dans une tranche et un basculement nul des moments magnétiques des particules situées à l'extérieur de la tranche.

La figure 3b montre schématiquement l'essentiel de l'invention. En effet l'excitation réfléchissante, appliquée en présence d'un même gradient que l'excitation basculante, a tout simplement un spectre décalé en fréquence de manière à ne provoquer la réflexion de la dispersion de phase de la précession de moments magnétiques que pour des particules qui ont atteint, au moment de cette excitation réfléchissante, une tranche 27 adjacente à la tranche 26 où avait été provoquée l'excitation basculante initiale. Autrement dit le spectre 39 de l'excitation réfléchissante 19 est adjacent au spectre 38 de l'excitation 18 (si le gradient de sélection est à chaque fois de même force). A l'examen de la figure 2d on se rend compte que le seul signal de RMN qui est susceptible de renaître au bout du temps d'écho $T_e$ est le signal de RMN relatif aux particules mobiles. Le signal relatif aux particules fixes ne renait pas : il reste nul. Il en résulte que la dynamique relative du signal de RMN concernant les particules mobiles par rapport au signal de RMN concernant les particules fixes est maintenant infinie. Dans le deuxième état de la technique cité cette dynamique relative était défavorable au signal de RMN concernant les particules mobiles.

Dans une variante, l'impulsion 19 de spectre 39 est remplacée par une impulsion réfléchissante de spectre 40, 41 (fig. 3c). C'est à dire que l'on s'intéresse en fait aux particules mobiles ayant quitté la tranche 26 et ayant migré, au moment de l'application de l'impulsion d'excitation réfléchissante, à droite (27) ou à gauche (28) de la tranche 26. On peut cependant procéder différement. Plutôt que d'utiliser une excitation basculante produisant son effet dans une seule tranche et une excitation réfléchissante produisant son effet de part et d'autre de la tranche basculée, on préfère provoquer un basculement des moments magnétiques des particules situées dans deux tranches voisines, 27 et 28 (figure 3d, $E_B$, 42,43), et ne provoquer la réflexion de la dispersion de phase que dans une seule tranche 26 au moyen d'une excitation réfléchissante dont le spectre 44 (fig 3e) est limité à cette seule tranche, adjacente de part et d'autre aux deux tranches voisines 27 et 28. D'une manière préférée on pourra même reconnaitre le sens de migration des particules excitées, en choisissant pour les deux tranches voisines 27 et 28 des spectres dont les composantes spectrales 42 et 45 sont de préférence à phase inverse d'une tranche à l'autre.

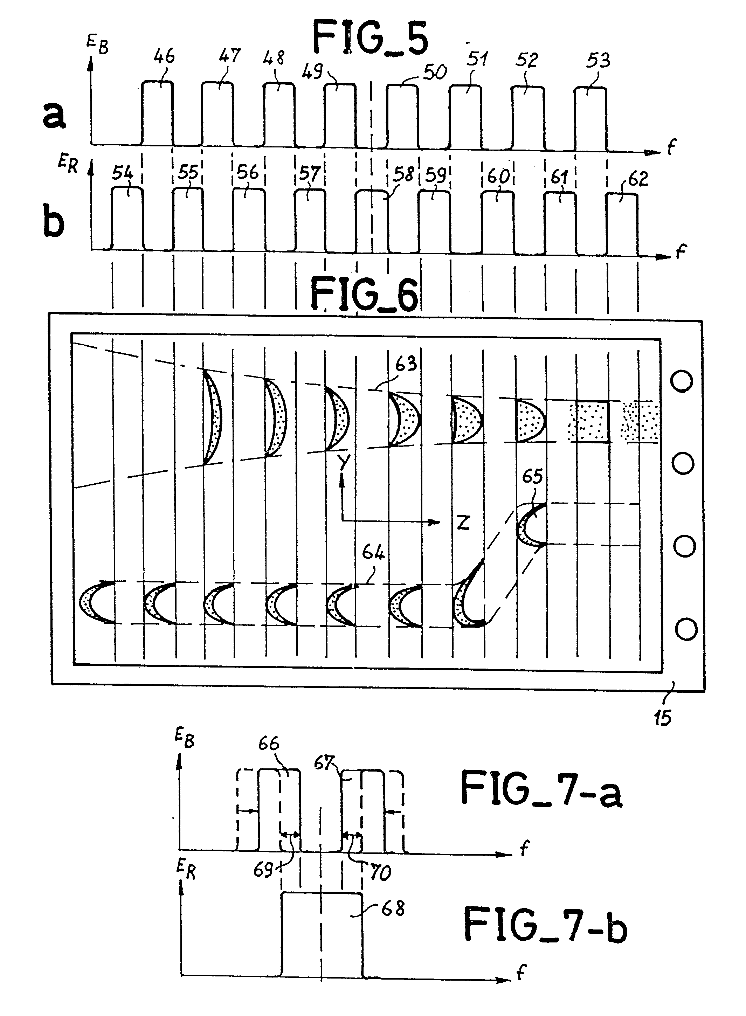

On peut encore procéder différement dans la mesure où on cherche essentiellement à réaliser une image des parties en mouvement dans le corps. Dans ce cas on choisit de préférence une excitation basculante dont le spectre est représenté sur la figure 5a. Avec une telle excitation basculante au moment de l'application du gradient de sélection on excite la résonance dans plusieurs tranches voisines simultanément. Par exemple içi du fait que l'excitation basculante comporte (schématiquement) des spectres de basculement limités dans huit domaines fréquentiels numérotés 46 à 53, on peut simultanément examiner ce qui se passe dans huit tranches voisines. Dans ces conditions le spectre, figure 5b, de l'excitation réfléchissante correspondante est entrelacé avec celui de l'excitation basculante. Il comporte dans l'exemple représenté 9 domaines de fréquences numérotés de 54 à 62.

La figure 6 montre l'image ainsi obtenue à l'aplomb des figures 5a et 5b. En effet il y a une correspondance intîme, à cause du gradient de sélection placé sur le même axe que le gradient de lecture, entre les domaines de fréquences des excitations et les tranches géographiques du corps 2. La figure 6 montre aussi les axes Y et Z de description de l'image : le premier, parce qu'il correspond au gradient de codage de phase, le second parce qu'il correspond à la fois au gradient de selection et au gradient de lecture. La figure 6 montre une coupe selon un tel plan Y Z du corps 2 à l'endroit où passent deux tubes d'écoulement respectivement 63 et 64 (figure 4). Pour simplifier la figure le tube d'écoulement 64 présente un coude 65 caractéristique. De plus dans le tube 64 l'écoulement possède des caractéristiques constantes le long du tube. Dans le tube 63 l'écoulement passe, de gauche à droite dans l'image, d'un régime laminaire à un régime turbulent.

La localisation des images doit d'abord être rappelée. Alors que les particules ont été excitées pendant qu'elles se trouvaient dans une tranche, par exemple à l'aplomb du spectre 46, elles ont été au bout d'une durée $T_e/2$ plus tard soumises à une impulsion réfléchissante. Elles se situaient alors sensiblement au droit d'une tranche correspondant au spectre 55 (ou 54 selon leur sens). Leur signal de RMN est mesuré au bout d'un temps $T_e$ alors qu'elles se trouvent sensiblement décalées symétriquement par rapport au domaine géographique correspondant au domaine spectral 55, c'est à dire en gros à l'aplomb de la tranche 47. Si le nombre des coupes de l'image est suffisant et si les coupes sont suffisamment fines, cet effet a peu d'incidence bien que dans le conduit 64 les particules à l'aplomb de la tranche 47 au moment de leur excitation basculante voient leur signal de RMN mesurer alors qu'elles se retrouvent sensiblement à l'aplomb de la tranche 46. Lorsque l'écoulement est laminaire toutes les particules sont animées sensiblement de la même vitesse. La répartition de ces particules, tube 64, est peu espacée selon l'axe Z. Par contre quand l'écoulement est turbulent, tube 63 à droite, les particules sont réparties dans l'espace sur une plus grande longueur. Le signal y est moins contrasté. Cette répartition, empiète de part et d'autre des tranches.

L'épaisseur des tranches intervient en fonction de la gamme de vitesse que l'on s'attend à rencontrer. Par exemple une vitesse nominale de 1m par seconde, équivalente à 1mm par milliseconde, revient à choisir, avec un temps d'écho $T_e$ égal à 40 ms, une épaisseur de la tranche soumise à l'impulsion à réfléchissante égale à 20 mm. En effet au moment de l'application de l'excitation réfléchissante les particules les plus rapides, animées de la vitesse nominale, auront parcouru sensiblement 20 mm, tandis que les particules les moins rapides n'auront presque pas bougé par rapport à la tranche basculée. Au bout du temps d'écho $T_e$ ces particules se trouvent réparties dans une épaisseur sensiblement égale au double de l'épaisseur de la tranche où est appliquée l'impulsion réfléchissante si l'écoulement est fortement turbulent.

Dans l'exemple indiqué, avec un temps d'écho de 40 ms il est possible de choisir un temps de répétition $T_r$ entre chaque séquence de l'ordre de 100 ms. Ce temps est faible. Il est favorable à la mesure des phénomènes mobiles. En effet la synchronisation fréquente est plus facile, et on peut pendant une durée moyenne de 750 ms d'un cycle cardiaque normal éspérer pouvoir faire jusqu'à sept acquisitions successives de manière à montrer sept états d'écoulement à différentes phases de ce cycle cardiaque. Une conséquence de ce faible temps de répétition est que la repousse de l'aimantation des moments magnétiques n'est pas très forte pendant cette durée faible par rapport à un temps de relaxation spin réseau, $T_1$, moyen de l'ordre de 500 ms. Cependant, cette repousse faible ne concerne que les moments magnétiques des parties fixes. Elle ne concerne pas les moments magnétiques des parties mobiles qui sont constamment renouvelées dans la coupe. La conséquence en est plutôt favorable puisqu'elle s'exerce au profit d'un contraste encore meilleur dans la représentation des parties mobiles par rapport aux parties fixes.

Cependant en agissant ainsi on n'est pas gagnant dans tous les domaines. En effet, dans le coeur, ce qui bouge est d'une part le sang et d'autre part le muscle cardiaque. . Il en résulte que si on abaisse trop le temps de répétition $T_r$, le contraste en $T_1$ ne devient plus perceptible. Et malheureusement, le sang et le muscle cardiaque ont déjà des temps de relaxation $T_1$ voisins. Aussi dans l'image des parties mobiles on voit bien des choses mais on ne sait plus discriminer ce qui concerne le sang et ce qui concerne le muscle cardiaque. Il en résulte qu'en définitive, pour que cette discrimination soit possible il faut alors augmenter le temps de répétition, un peu inutilement vis à vis du reste. De sorte que tout les avantages de la méthode ne pourraient pas être à disposition.

Dans l'invention on résoud ce problème de différenciation sang-muscle cardiaque en ne séparant plus complètement les domaines d'action des excitations basculantes et des excitations réfléchissantes. Mais au contraire on les fait légèrement s'entremêler. La figure 7 montre une telle situation où l'excitation basculante comporte deux domaines spectraux respectivement 66 et 67 qui interpénètrent légèrement un domaine de fréquence 68 consacré à l'excitation réfléchissante. Il en résulte que les protons où les particules fixes se situant dans l'espace géographique correspondant aux parties communes de ces spectres (dont les plages en fréquence 69 et 70 sont montrées sur la figure 7) contribuent au signal de RMN et révèlent en quelque sorte la structure du corps examiné. Ce faisant on perd en dynamique relative mais on gagne en lisibilité de l'image. Et ceci est particulièrement intéressant si on réalise l'image dans le plan des tranches basculées ou réfléchies. Dans ce cas le gradient de lecture est perpendiculaire au gradient de sélection et au gradient de codage de phase. L'image obtenue est classique, elle n'est pas une image projetée. Sachant par ailleurs que lorsque le muscle cardiaque se comprime selon une direction le sang est éjecté selon une direction orthogonale à cette direction, il est possible de reconnaître dans les mouvements représentés la part qui appartient au muscle cardiaque et la part qui appartient au sang. Il est possible alors au praticien de diagnostiquer le cas échéant un trouble du flux ou un trouble de la musculation. Comme on l'a évoqué précédemment l'image des parties fixes vient faire baisser la dynamique relative de l'image des parties mobiles par rapport à l'image des parties fixes. Il importe donc de choisir à bon escient la largeur des plages 69 et 70. A cette fin on peut procéder de deux manières différentes. Où bien les spectres de l'impulsion basculante sont rapprochés les uns des autres, (sens des flèches, figure 7a), où bien le spectre de l'excitation réléchissante est au contraire élargi. Dans l'image classique des tranches basculées et réfléchies la distinction entre le muscle cardiaque et le sang est automatique : le muscle reste dans la tranche basculée alors que le sang rejoint la tranche réfléchissante si le gradient de sélection est parallèle à ce flux.

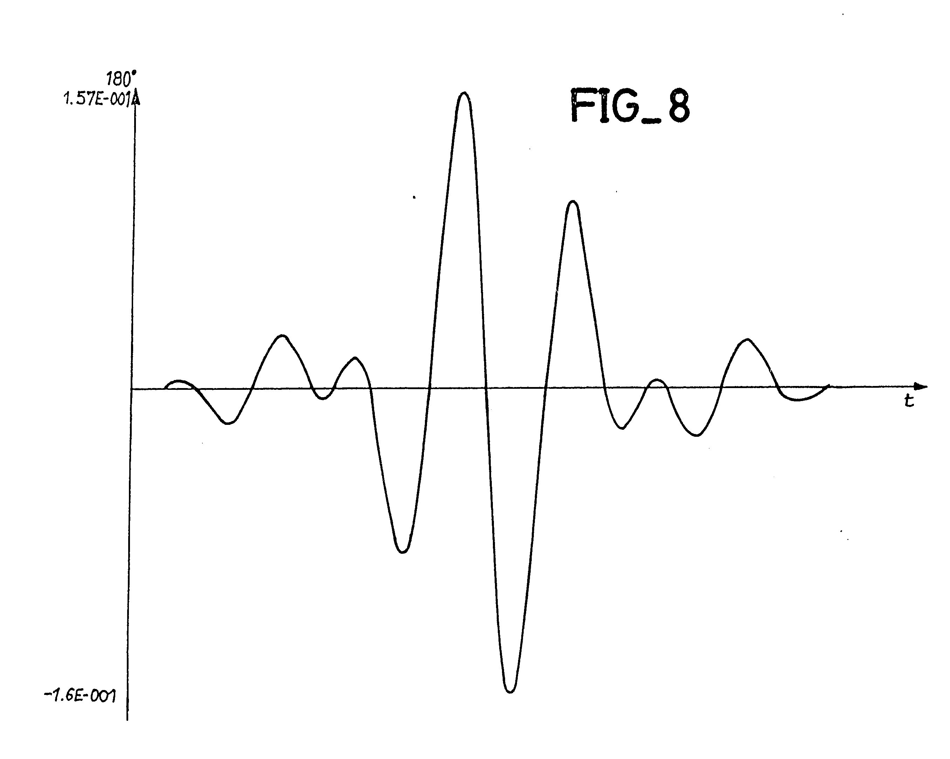

Il importe maintenant de dire comment sont déterminées les enveloppes temporelles des excitations radiofréquence qui correspondent aux diagrammes spectraux schématiques des figures 3,5,et 7. Concernant les diagrammes 38 et 39, l'état de la technique en imagerie par RMN, en particulier celui des techniques dites multicoupes, permet déjà de produire les excitations correspondantes. Il en va de même d'ailleurs de l'excitation réfléchissante de spectre 44. Seuls des décalages en fréquence sont nécéssaires. Pour la détermination de l'excitation réfléchissante dont le spectre est coté 40 et 41 on peut procéder empiriquement, ou selon une méthode décrite dans une demande de brevet européen n° 85 401 746 déposée le 6 SEPTEMBRE 1985. On peut aussi de préférence utiliser une méthode de détermination d'une impulsion d'excitation décrite dans une demande de brevet français n° 86 10179 déposée le 11 JUILLET 1986. Dans cette dernière méthode, on décrit une nouvelle approche de la définition des impulsions d'excitation radiofréquence. Sans entrer dans le détail de cette invention, on sait qu'elle aboutit à des excitations optimisées. Celles ci sont directement données içi dans des exemples particuliers. Le tableau n°1 ci après tabule l'enveloppe temporelle d'une excitation basculante dont le spectre est 40-41. Les tableaux de valeurs n° 2 et 3, (ce dernier non normalisé), représentent des excitations basculantes de spectre 43,42 ou 45,42 respectivement. La figure 8 montre l'allure de l'excitation correspondant à ce spectre 45,42. On peut s'écarter des enveloppes temporelles ainsi défini de plus ou moins 5 pour cent sans altérer trop les images. Ces enveloppes temporelles servent à moduler en amplitude un signal d'excitation oscillant à une fréquence égale à la fréquence de résonance fondamentale fo de la machine de RMN utilisée.

| | | |
|---|---|---|
| 7C   =0 | -0.33495 | -0.15273 |
| -0.????? | -0.34810 | -0.14383 |
| -0.00614 | -0.27607 | -0.11731 |
| -0.01222 | -0.20465 | -0.09020 |
| -0.03649 | 0.03496 | -0.04216 |
| -0.05254 | 0.18542 | -0.02541 |
| -0.06932 | 0.33562 | -0.00367 |
| -0.09236 | 0.65143 | 0.01031 |
| -0.09627 | 0.78332 | 0.01706 |
| -0.10419 | 0.91520 | 0.02382 |
| -0.10057 | 1.00000 | 0.03126 |
| -0.08950 | 0.94964 | 0.03199 |
| -0.07843 | 0.89967 | 0.03272 |
| -0.03407 | 0.66033 | 0.00733 |
| -0.01661 | 0.50250 | -0.00765 |
| 0.00035 | 0.34466 | -0.02273 |
| 0.00565 | -0.00255 | -0.02942 |
| 0.00028 | -0.17347 | -0.01717 |
| -0.00930 | -0.35638 | -0.00592 |
| -0.03292 | -0.66231 | 0.03861 |
| -0.03327 | -0.80021 | 0.05687 |
| -0.03362 | -0.91810 | 0.07513 |
| -0.02891 | -0.98949 | 0.09382 |
| -0.02356 | -0.91977 | 0.09452 |
| -0.01821 | -0.85005 | 0.09523 |
| -0.00290 | -0.60094 | 0.08112 |
| 0.00921 | -0.45615 | 0.05639 |
| 0.02132 | -0.31136 | 0.05165 |
| 0.06357 | -0.04156 | 0.02466 |
| 0.09114 | 0.06129 | 0.01557 |
| 0.11570 | 0.16413 | 0.00647 |
| 0.17993 | 0.27679 | |
| 0.18968 | 0.29092 | |
| 0.20072 | 0.30504 | |
| 0.19497 | 0.26605 | |
| 0.17736 | 0.22847 | |
| 0.15976 | 0.19089 | |
| 0.09733 | 0.11058 | |
| 0.05759 | 0.08105 | |
| 0.01720 | 0.05153 | |
| -0.06518 | 0.02968 | |
| -0.10035 | 0.03861 | |
| -0.13552 | 0.04755 | |
| -0.16307 | 0.09216 | |
| -0.18639 | 0.11979 | |
| -0.18971 | 0.14743 | |
| -0.15664 | 0.19483 | |
| -0.13076 | 0.20227 | |
| -0.10438 | 0.20970 | |
| -0.05316 | 0.18240 | |
| -0.03653 | 0.15453 | |
| -0.01990 | 0.12666 | |
| -0.02334 | 0.05046 | |
| -0.04752 | 0.00801 | |
| -0.07171 | -0.03444 | |
| -0.15750 | -0.11120 | |
| -0.20971 | -0.13892 | |
| -0.25991 | -0.16664 | |
| -0.34967 | -0.19435 | |
| -0.36776 | -0.19357 | |

TAB 1

```
50    50    -0.29375    -0.00693
-0.00427    -0.02273
-0.00950     0.25224
-0.01172     0.50978
-0.01357     0.72519
-0.00619     0.85206
 0.00056     0.98461
 0.00874    ⌈1.00000
 0.01637     0.93933
 0.02170     0.91264
 0.02294     0.63612
 0.01863     0.43116
 0.00793     0.21687
-0.00918     0.01206
-0.03131    -0.16735
-0.05812    -0.30923
-0.08550    -0.40599
-0.11080    -0.45500
-0.13103    -0.45863
-0.14234    -0.42364
-0.14272    -0.36011
-0.13104    -0.27937
-0.10746    -0.19495
-0.07362    -0.11614
-0.03249    -0.05139
 0.01183    -0.00750
 0.05468     0.01451
 0.09135     0.01497
 0.11775    -0.00110
 0.13102    -0.02530
 0.13004    -0.05991
 0.11563    -0.08924
 0.09039    -0.11043
 0.06037    -0.11949
 0.03010    -0.11376
 0.00569    -0.09348
-0.00459    -0.06049
 0.00248    -0.01833
 0.02931     0.02841
 0.07654     0.07469
 0.13958     0.11573
 0.21241     0.14750
 0.28505     0.16722
 0.34710     0.17348
 0.38735     0.16610
 0.39560     0.14749
 0.36414     0.11999
 0.28898     0.08694
 0.17062     0.05189
 0.01431     0.01822
-0.17015    -0.01121
-0.36892    -0.03436
-0.56610    -0.05010
-0.74128    -0.05823
-0.87420    -0.05937
-0.94883    -0.05483
-0.95334    -0.04629
-0.88313    -0.03562
-0.74172    -0.02458
-0.53988    -0.01466
```

TAB 2

```
5.94634752733279E-004      4.09529145423517E-002      9.66455433917539E-004
1.32403663594024E-003      3.16851059005395E-003
1.63433969320329E-003     -3.51459091958796E-002
1.47323220115999E-003     -7.10697735247354E-002
8.63404269931087E-004     -1.01637540113683E-001
-9.25957366879662E-005    -1.24365210874600E-001
-1.21355392979753E-003    -1.37269143824179E-001
-2.28263217295255E-003    [-1.29413034457769E-001
-3.02567346501103E-003    -1.31023951476345E-001
-3.19819678752281E-003    -1.13320769558465E-001
-2.59742925009203E-003    -8.86340783294985E-002
-1.10609604897652E-003    -6.01089683778016E-002
1.27968333624662E-003     -3.02344632709598E-002
4.43417235736681E-003     -1.68092615336180E-003
8.10254994827049E-003      2.33305022732000E-002
1.19196917907744E-002      4.31105502445236E-002
1.54465379127961E-002      5.66003160239444E-002
1.82676574029759E-002      6.34340621731155E-002
1.98439606798296E-002      6.39387276000529E-002
1.98974281031477E-002      5.90613967624859E-002
1.82691372721344E-002      5.02043205722031E-002
1.49819290607122E-002      3.90180981480821E-002
1.02629729413396E-002      2.71792054850973E-002
4.53004155195380E-003      1.61915765383734E-002
-1.64942840238632E-003     7.23346608471742E-003
-7.62299662301633E-003     1.05957489166972E-002
-1.27349059993832E-002    -2.02262762681981E-003
-1.64153895354803E-002    -2.08735020111648E-003
-1.22660699956899E-002     1.53964659256359E-004
-1.91290747758913E-002     3.94439676855144E-003
-1.61277373960091E-002     3.35157795026269E-003
-1.26709207264455E-002     1.24405910999666E-002
-8.41648894537149E-003     1.54020512785752E-003
-4.19624835005536E-003     1.66452574410781E-002
-7.93624891469165E-004     1.58559204393006E-002
6.81675248157193E-004      1.30324569238166E-002
-3.45611556204049E-004     8.43312975418413E-003
-4.16929802116351E-003     2.55496235092640E-003
-1.07260311180311E-002    -3.96043782898772E-003
-1.95151921959785E-002    -1.04131213999235E-002
-2.96121364710193E-002    -1.61341200838650E-002
-3.97393624030686E-002    -2.05640739544951E-002
-4.83903682830735E-002    -2.33128358693536E-002
-5.40031179731828E-002    -2.41850647195680E-002
-5.51514264619836E-002    -2.31561454330596E-002
-5.07660592034970E-002    -2.05619734900582E-002
-4.02879082055109E-002    -1.67283714137108E-002
-2.37866223549189E-002    -1.21199031529486E-002
-1.99480292280548E-003    -7.23358078860139E-003
2.37204581872737E-002     -2.54054542633076E-003
5.14319461159768E-002      1.56297220112141E-003
7.89218853032221E-002      4.79068711266535E-003
1.03344601795946E-001      6.98476330411237E-003
1.21875225748092E-001      8.11741792767385E-003
[1.32279607560649E-001     9.27725350861571E-003
1.32907416451109E-001      7.64361540847912E-003
1.23119978026389E-001      6.45342406707568E-003
1.03405157808774E-001      4.96541137875159E-003
7.52659636550023E-002      2.04394730309683E-003
```

TAB 3

## Revendications

1 - Procédé de mesure des flux dans une expérimentation de résonance magnétique nucléaire (RMN) dans laquelle :
- on soumet (1) un corps (2) à examiner (17), comportant des parties en mouvement, à un champ magnétique orientateur ($B_0$),
- on excite (4-11) sélectivement (18) au moins une tranche (38) de ce corps de manière à faire basculer l'orientation des moments magnétiques des parties de ce corps situées dans cette tranche,
- on relève (4,12,13) le signal de résonance résultant de cette excitation basculante, et
- on le traite (14) pour en extraire une information de flux relative aux parties en mouvement,
- l'excitation comportant, ultérieurement à l'excitation basculante mais antérieurement au relevé, l'application d'au moins une excitation réfléchissante (40,41) dont l'action est limitée dans l'espace à au moins une tranche du corps adjacente à la tranche excitée selectivement par l'excitation basculante, caractérisé en ce que l'excitation comporte l'application d'au moins une excitation réfléchissante dont l'action est simultanément limitée dans l'espace à au moins deux tranches voisines (27,28), ces tranches voisines étant adjacentes de part et d'autre à au moins une tranche (26) du corps excitée sélectivement par l'excitation basculante (fig. 3a, 3c).

2 - Procédé de mesure des flux dans une expérimentation de résonance magnétique nucléaire (RMN) dans laquelle :
- on soumet (1) un corps (2) à examiner (17), comportant des parties en mouvement, à un champ magnétique orientateur ($B_0$),
- on excite (4-11) sélectivement (18) au moins une tranche (38) de ce corps de manière à faire basculer l'orientation des moments magnétiques des parties de ce corps situées dans cette tranche,
- on relève (4,12,13) le signal de résonance résultant de cette excitation basculante, et
- on le traite (14) pour en extraire une information de flux relative aux parties en mouvement,
- l'excitation comportant, ultérieurement à l'excitation basculante mais antérieurement au relevé, l'application d'au moins une excitation réfléchissante (40,41) dont l'action est limitée dans l'espace à au moins une tranche du corps adjacente à la tranche excitée selectivement par l'excitation basculante, caractérisé en ce que l'excitation basculante comporte l'excitation (42,43) limitée simultanément à au moins deux tranches voisines (27,28) du corps et en ce que l'excitation réfléchissante (44) est telle qu'au moins une région (26) de l'espace où est limitée son action est une région adjacente aux deux tranches voisines ainsi soumises à l'excitation basculante (fig. 3d, 3e).

3 - Procédé selon la revendication 2, caractérisé en ce que l'excitation basculante des deux tranches voisines est faite en opposition de phase (42,45) de manière à discriminer dans le signal relevé le sens du mouvement des parties en mouvement.

4 - Procédé selon la revendication 1 ou la revendication 2, caractérisé en ce que l'excitation basculante comporte une excitation (46.53) dont l'action simultanée est limitée à une première pluralité de tranches (fig 5a) et en ce que l'excitation réfléchissante correspondante comporte l'excitation simultanée d'une deuxième pluralité de tranches intercalées géométriquement avec les tranches basculées (fig. 5b).

5 - Procédé selon l'une quelconque des revendications 1 à 3, caractérisé en ce que le traitement comporte la mise en image (15) des informations de flux (fig. 7).

6 - Procédé de mesure des flux dans une expérimentation de résonance magnétique nucléaire (RMN) dans laquelle :
- on soumet (1) un corps (2) à examiner (17), comportant des parties en mouvement, à un champ magnétique orientateur ($B_0$),
- on excite (4-11) sélectivement (18) au moins une tranche (38) de ce corps de manière à faire basculer l'orientation des moments magnétiques des parties de ce corps situées dans cette tranche,
- on relève (4,12,13) le signal de résonance résultant de cette excitation basculante, et
- on le traite (14) pour en extraire une information de flux relative aux parties en mouvement,
- l'excitation comportant, ultérieurement à l'excitation basculante mais antérieurement au relevé, l'application d'au moins une excitation réfléchissante (40,41) dont l'action est limitée dans l'espace à au moins une tranche du corps adjacente à la tranche excitée selectivement par l'excitation basculante, caractérisé en ce que la région (68) de l'espace ou l'excitation basculante excerce son action empiète en partie sur la région (68) de l'espace où l'excitation réfléchissante exerce son action (fig. 7).

7 - Procédé selon la revendication 1, caractérisé en ce que l'excitation réfléchissante a une enveloppe temporelle représentée sur la figure 8 et dont les valeurs d'amplitude en fonction du temps sont sensiblement telles que tabulées dans le tableau 3.

8 - Procédé selon la revendication 2, caractérisé en ce que l'excitation basculante a une enveloppe temporelle dont les valeurs d'amplitude en fonction du temps sont sensiblement telles que tabulées dans le tableau 2.

9 - Procédé selon la revendication 2, caractérisé en ce que l'excitation basculante a une enveloppe temporelle dont les valeurs d'amplitude en fonction du temps sont sensiblement telles que tabulées dans le tableau 1.

# FIG_1

$B_0$

Y

6

5

4

X

Z

10

9

7

8

17

2

12

11 RF

13

14

15

16

SEQUENCE

0291387

0291387

FIG_2

0291387

FIG_3

a

b

c

d

e

FIG_4

0291387

FIG_5

FIG_6

FIG_7-a

FIG_7-b

FIG_8

Office européen
des brevets

**RAPPORT DE RECHERCHE EUROPEENNE**

Numero de la demande

EP  88 40 1070

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| P,X | EP-A-0 234 526  (SPECTROSPIN AG) <br> * Page 9, ligne 1 - page 13, ligne 6 * <br> --- | 1,5,6 | A 61 B   5/02 <br> G 01 N  24/08 <br> G 01 F   1/716 |
| A | US-A-4 602 641  (FEINBERG) <br> * Colonne 3, ligne 59 - colonne 4, ligne 56 * <br> --- | 1,5,6 | |
| A | US-A-4 574 240  (LIBOVE et al.) <br> * Colonne 7, ligne 54 - colonne 8, ligne 6 * <br> --- | 1,5,6 | |
| A | IEEE TRANSACTIONS ON MEDICAL IMAGING, vol. MI-5, no. 3, septembre 1986, pages 140-151, IEEE, New York, US; D.G. NISHIMURA et al.: "Magnetic resonance angiography" <br> * Chapitre III B: "Cancelling excitation"; pages 146-147 * <br> --- | 1,5 | |
| A | EP-A-0 117 134  (MACOVSKY) <br> * Page 17, lignes 11-20 * <br> --- | 1,5,6 | **DOMAINES TECHNIQUES RECHERCHES (Int. Cl.4)** |
| A | EP-A-0 126 381  (GENERAL ELECTRIC CO.) <br> * Page 11, ligne 24 - page 13, ligne 14 * <br> ----- | 1,5,6 | G 01 N   24/00 |

Le présent rapport a été établi pour toutes les revendications

| Lieu de la recherche | Date d'achèvement de la recherche | Examinateur |
|---|---|---|
| LA HAYE | 05-08-1988 | DIOT P.M.L. |